Europäisches Patentamt

(19) European Patent Office

Office européen des brevets

(11) Publication number : **0 486 244 A1**

## (12) EUROPEAN PATENT APPLICATION

(21) Application number : 91310398.2

(22) Date of filing : 11.11.91

(51) Int. Cl.⁵ : **H01L 21/90,** H01L 21/285, H01L 21/60

(30) Priority : 16.11.90 US 614635

(43) Date of publication of application :
20.05.92 Bulletin 92/21

(84) Designated Contracting States :
DE FR GB IT

(71) Applicant : SGS-THOMSON
MICROELECTRONICS, INC. (a Delaware
corp.)
1310 Electronics Drive
Carrollton, TX 75006 (US)

(72) Inventor : **Miller, Robert Otis**
**5523 Vaden Street**
**The Colony, Texas 75056 (US)**
Inventor : **Wei, Che-Chia**
**4313 Purdue Circle**
**Plano, Texas 75093 (US)**

(74) Representative : **Palmer, Roger et al**
**PAGE, WHITE & FARRER 54 Doughty Street**
**London WC1N 2LS (GB)**

(54) Method of producing low resistance contacts.

(57)    The method for fabrication of low resistance semiconductor contacts includes depositing an insulating layer (14) over the integrated circuit. An adhesion layer (16) is then formed over the insulating layer. A contact opening (18) is formed through the adhesion layer and the insulating layer. A metal silicide layer (20) is then deposited over the integrated circuit including the contact opening. The metal silicide layer and adhesion layer are then etched to form interconnections.

FIG. 4

The present invention relates generally to semiconductor integrated circuit processing, and more specifically to producing low resistance contacts.

With the advent of silicon-gate MOS technology, it has become necessary and desirable to use multiple layers of doped polysilicon as interconnections in lieu of metals. Polysilicon leads may be connected directly to the silicon substrate or to other polysilicon in selected locations on the integrated circuit (IC) chip. The use of polysilicon instead of metals as an interconnect provides greater stability during subsequent high-temperature processing of the IC chip.

Polysilicon, however, even when heavily doped, has a much higher resistivity than metal. Therefore, in modern applications of polysilicon as a local interconnect, in order to greatly reduce this resistivity, the polysilicon lead is usually shunted or strapped with a refractory metal silicide layer. An appropriate metal silicide film is deposited on top of a layer of polysilicon of nominal thickness. The resulting bilayer film, known as polycide, is then masked and etched to form interconnect leads.

The polysilicon in such a bilayer film is not used as a conductor except in contacts. Most of the current flowing in a polycide lead is in the metal silicide portion of the bilayer film. The polysilicon layer is present as an adhesion layer between the metal silicide and the dielectric layer underlying the polysilicon layer. Polysilicon as an adhesion layer has been found to be practically indispensable.

When polysilicon is connected to an underlying layer of polysilicon or the silicon substrate before the deposition of the upper polysilicon layer, silicon dioxide ($SiO_2$) has had a chance to form on the lower surface of the contact. The formation of $SiO_2$ often causes large increases in contact resistance between the polysilicon layer and the underlying layer. This increase in resistance cannot be overcome when polysilicon is deposited by the generally accepted method of chemical vapor deposition (CVD) for two reasons. First, CVD reactors usually cannot accommodate pre-cleaning native oxide from the underlying surface. Second, in hotwall reactors, commonly used for polysilicon deposition, wafers are loaded into a hot zone in an ambient that does not entirely exclude oxygen, thereby enhancing growth of $SiO_2$.

Additionally, extra masking steps are required in implantations to dope the polysilicon when it is used to connect both N- and P-type underlying layers. Further, since the polysilicon must be doped, only silicon of the same conductivity type as that of the underlying polysilicon layer can make a suitable contact. If the conductivity types of the two layers are different, a PN diode is formed which prevents current from flowing in both directions.

It would be desirable for a semiconductor process to overcome the oxide growth problem between the polysilicon adhesion layer and the underlying polysilicon or silicon substrate layer. It would further be desirable for such fabrication technique to eliminate the polysilicon layer in the contact opening but to retain the polysilicon layer as an adhesion layer elsewhere.

It is therefore an object of the present invention to provide a semiconductor fabrication technique which minimizes resistance in contacts.

It is a further object of the present invention to provide such a semiconductor fabrication process for making low resistance contacts which are suitable for use with small device geometries.

It is yet another object of the present invention to provide a semiconductor fabrication process which is easily adapted for use with standard integrated circuit fabrication process flows.

Therefore, according to the present invention, an insulating layer in formed over the integrated circuit. An adhesion layer is then formed over the insulating layer. The insulating layer and adhesion layer are etched to form contact openings. Selected portions of the integrated circuit are exposed in such openings. A metal silicide layer is then formed over the integrated circuit. The metal silicide layer and adhesion layer are etched to form interconnections.

The novel features believed characteristic of the invention are set forth in the appended claims. The invention itself, however, as well as a preferred mode of use, and further objects and advantages thereof, will best be understood by reference to the following detailed description of an illustrative embodiment when read in conjunction with the accompanying drawings, wherein:

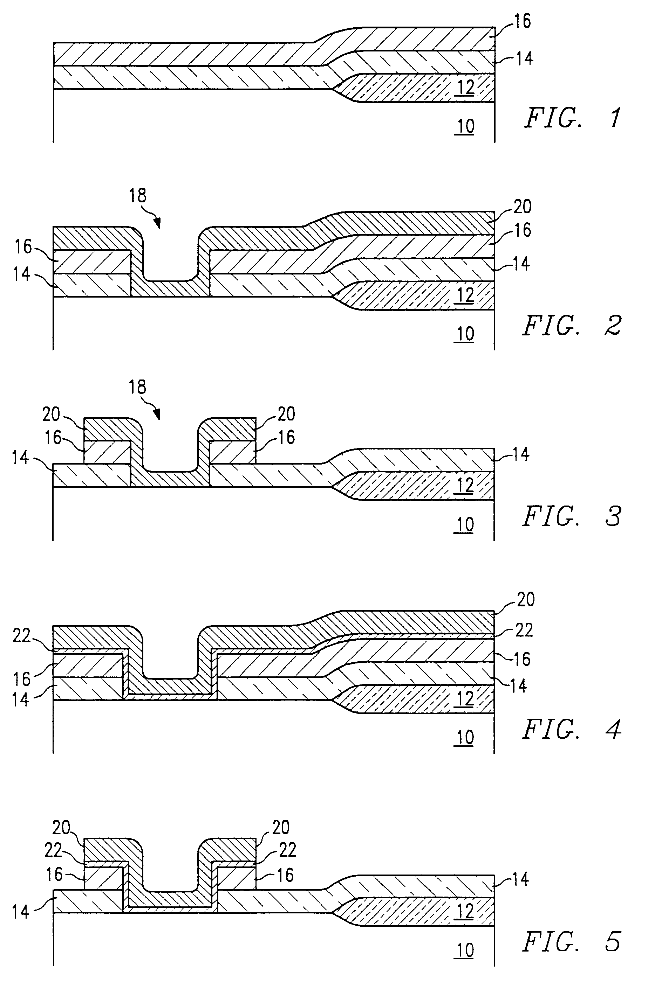

Figures 1-5 illustrate a preferred process flow according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. Figures 1-5 represent a cross-section of a portion of an integrated circuit during fabrication. The Figures are not drawn to scale, but instead are drawn so as to illustrate the important features of the invention.

Referring to Figure 1, an integrated circuit is to be formed in a conductive layer 10. In the Figures, conductive layer 10 is shown as the substrate of an integrated circuit. As will be appreciated by those skilled in the art, the techniques described herein can also be used to form contacts to lower interconnect layers formed from materials such as polycide or refractory metal silicides. If the conductive layer 10 is a doped silicon substrate, it can have either a p or n conductivity type. Selected regions of the substrate are oxidized to form a field oxide 12 as known in the art. Active devices are formed in those portions of layer 10 not covered by field oxide 12. An insulating layer 14 is deposited over the wafer surface. Layer 14 is typically silicon dioxide (SiO$_2$). An adhesion layer 16 of polysilicon is deposited over the insulating layer 14.

Referring to **Figure 2**, the integrated circuit is then patterned and etched to form a contact opening 18 through the insulating layer 14 and adhesion layer 16 exposing a portion of the conducting layer 10. After the contact opening is formed, the photoresist is stripped away along with any oxide layer that may have grown in the presence of oxygen. During the etch process to strip the resist, the adhesion layer 16 protects the insulating layer 14 from degradation. A metal silicide layer 20 is then deposited over the entire surface including the contact opening 18. The metal silicide layer is preferably tungsten silicide or tantalum silicide. Tungsten silicide is typically deposited by known chemical vapor deposition techniques. Tantalum silicide is deposited by known sputtering techniques.

Referring to **Figure 3**, the adhesion layer 16 and the metal silicide layer 20 are patterned and etched to form interconnections. Interconnects or leads are connections between conducting regions to provide good electrical contact and allow for the flow of electrical current. Any oxide between conducting layers acts to substantially increase resistance and must be completely removed. Because of the removal of the polysilicon layer 16 from the contact opening 18 before the opening was made, the polysilicon adhesion layer 16 does not act as a contact medium. Instead, the polysilicon layer acts as an adhesion layer between the metal silicide layer 20 and the insulating layer 14. The metal silicide layer 20 thus contacts the exposed portion of the underlying conducting layer 10 to form a contact with a lower resistance. The polysilicon layer 16, however, remains on the insulating layer to provide adhesion between the insulating layer 14 and the metal silicide layer 20.

Referring to **Figure 4**, an alternative embodiment includes depositing and then annealing an oxide dissolving film 22 prior to the deposition of the metal silicide layer 20. This oxide dissolving film is preferably titanium or titanium nitride. A native oxide layer may grow on top of the exposed region of contact opening 18 under certain conditions before the metal silicide layer 20 can be deposited. Titanium and titanium nitride are known to dissolve native oxide and provide a low resistance interface between the metal silicide layer 20 and the underlying conducting layer 10.

Referring to **Figure 5**, the polysilicon adhesion layer 16, the titanium film 22, and the metal silicide layer 20 are patterned and etched to form interconnections as described above for **Figure 3**.

Deposition and patterning of the various layers may be varied to be made consistent with process flows for the devices being fabricated. In a typical embodiment, the insulating layer 14 will be deposited to a depth of approximately 500 to 2000 Angstroms.

The polysilicon adhesion layer 16 will typically be approximately 500 to 1000 Angstroms thick. The metal silicide layer 20 will be deposited to a depth of approximately 1000 to 2000 Angstroms. The oxide dissolving layer 22, if deposited before the metal silicide layer 20 will have a thickness of approximately 100 to 400 Angstroms.

The anneal process of the oxide dissolving layer 22 may also be varied to be made consistent with process flows for the devices being fabricated. In a typical embodiment, the anneal process of layer 22 will occur at temperatures of approximately 600 to 750 degrees Celsius.

Important advantages of the present invention over the prior art are the elimination of polysilicon as a contact, maintaining the polysilicon as an adhesion layer, and protecting the insulating layer beneath the polysilicon layer before metal silicide deposition during the etch process which strips the photoresist and cleans off any oxide layer which may have grown in the presence of oxygen. Etching the contacts through both the adhesion and insulating layers, thus eliminating polysilicon in the contact opening, a lower resistance contact is formed. Without polysilicon in the contact opening, the polysilicon does not need to be doped. If the polysilicon were in the contact opening, as in the prior art, the underlying silicon layer would have to be of the same conductivity type as the polysilicon; otherwise, a P-N diode, or rectifying contact would be formed at the junction preventing current from flowing in both directions. Instead, the polysilicon remains in its preferred role as an adhesion layer between the metal silicide layer and the remaining underlying insulating layer. In the present invention, the contact opening is filled with a metal silicide, thereby allowing the underlying silicon to be of either P or N conductivity type.

The insulating layer also acts as an etch stop layer during the process of patterning and etching the adhesion and metal silicide layers to form interconnections. Titanium or titanium nitride is easily deposited on the integrated circuit before the deposition of the metal silicide layer to remove or dissolve native oxide which can substantially increase resistance of the interconnect if allowed to grow.

As will be appreciated by those skilled in the art, the process steps described above can be used with nearly any conventional process flow. While the invention has been particularly shown and described with reference to a preferred embodiment, it will be understood by those skilled in the art that various changes in form and detail may be made therein without departing from the spirit and scope of the invention.

## Claims

1. A method of producing low resistance contacts in an integrated circuit comprising the steps of:
   forming a contact opening through an adhesion layer and an insulating layer; and
   forming a metal silicide interconnect layer over the surface of the integrated circuit.

2. A method of producing low resistance contacts in an integrated circuit comprising the steps of:
   forming an insulating layer over the integrated circuit;
   forming an adhesion layer over the insulating layer;
   etching the adhesion layer and insulating layer to form contact openings exposing selected portions of the integrated circuit;
   forming a metal silicide layer over the integrated circuit; and
   etching the metal silicide layer and the adhesion layer to form interconnections.

3. The method of claim 1 or claim 2, wherein the insulating layer is $SiO_2$.

4. The method of claim 1 or claim 2, wherein the adhesion layer is polysilicon.

5. The method of claim 1 or claim 2, wherein the metal silicide layer is sputtered onto or deposited by chemical vapor deposition on the integrated circuit.

6. The method of claim 1 or claim 5, wherein the metal silicide layer is tungsten silicide, or tantalum silicide.

7. The method of claim 1 or claim 2, wherein an oxide dissolving film is formed on the integrated circuit before the metal silicide layer is formed.

8. The method of claim 7, wherein the oxide dissolving film is deposited on the integrated circuit.

9. The method of claim 7, wherein the oxide dissolving film is annealed after deposition.

10. The method of claim 1 or claim 9, wherein the oxide dissolving film is titanium, or titanium nitride.

11. An electrical contact comprising:
    a conducting layer;
    an insulating layer over the conducting layer;
    an adhesion layer over the insulating layer;
    a contact opening through the adhesion layer and the insualting layer exposing a selected region of the conducting layer; and
    a metal silicide layer in the contact opening and over selected portions of the adhesion layer.

12. The device of claim 11, wherein the insulating layer is $SiO_2$.

13. The device of claim 11, wherein the adhesion layer is polysilicon.

14. The device of claim 11, wherein the metal silicide layer is tunsten silicide or tantalum silicide.

15. The device of claim 11 further comprising an oxide dissolving film disposed between the metal silicide layer and the exposed conducting layer region.

16. The device of claim 15, wherein the oxide dissolving film is titanium or titanium nitride.

FIG. 1

FIG. 2

FIG. 3

FIG. 4

FIG. 5

EP 0 486 244 A1

**European Patent Office**

**EUROPEAN SEARCH REPORT**

Application Number

EP 91 31 0398

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-2 226 446 (SAMSUNG ELECTRONICS CO. LTD) <br> * page 1, line 10 - page 2, line 35 * <br> * page 9, line 5 - page 10, line 20; claims 1-5,11; figures 1A-1D * | 1-16 | H01L21/90 <br> H01L21/285 <br> H01L21/60 |
| X | US-A-4 519 126 (SHENG T. HSU) <br> * column 2, line 11 - line 47; figures 1-3 * <br> * column 2, line 67 - column 3, line 4; claim 1 * | 1-5 <br> 11-13 | |
| Y | | 6-10, 14-16 | |
| Y | EP-A-0 388 563 (SGS-THOMSON MICROELECTRONICS) <br><br> * column 1, line 26 - column 2, line 34 * <br> * column 4, line 17 - column 5, line 37; figures 2-6 * <br> * column 6, line 52 - column 7, line 4 * | 6-10, 14-16 | |
| A | | 1,11 | |
| X | EP-A-0 097 918 (MATSUSHITA ELECTRONICS CORP.) <br> * page 7 - page 10; figures 3A-3E * <br> * page 12, last paragraph - page 13 * | 1,3,4 <br> 11-13 | TECHNICAL FIELDS SEARCHED (Int. Cl.5 ) |
| X | RESEARCH DISCLOSURE. <br> no. 275, March 1987, HAVANT GB <br> page 153; 'Methods of forming bridging contacts' <br> * the whole document * | 1,3-6, 11,14 | H01L |
| A | EP-A-0 310 108 (K.K. TOSHIBA) <br> * column 1, line 30 - line 52 * <br> * column 3, line 26 - column 4, line 6; figures 1A-1D * | 1,7-11 <br> 14-16 | |

The present search report has been drawn up for all claims

| Place of search | Date of completion of the search | Examiner |
|---|---|---|
| BERLIN | 19 FEBRUARY 1992 | P. KLOPFENSTEIN |

EPO FORM 1503 03.82 (P0401)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

6